# EUROPÄISCHE PATENTSCHRIFT

(11) **EP 1 236 384 B1**
(45) Veröffentlichungstag und Bekanntmachung des Hinweises auf die Patenterteilung: **10.12.2008**
(21) Anmeldenummer: 01976104.8
(22) Anmeldetag: 17.08.2001
(51) Int. Cl.: H05K 7/14

(54) **BETÄTIGUNGSELEMENT ZUM EIN- UND AUSHEBELN VON FLACHBAUGRUPPEN MIT KOMBINIERTEM ANZEIGE-/SCHALTELEMENT IM BETÄTIGUNGSHEBEL, FRONTSYSTEM FÜR EINE FLACHBAUGRUPPE MIT BETÄTIGUNGSELEMENT, FLACHBAUGRUPPE MIT DEM LETZTEN UND BAUGRUPPENTRÄGER MIT DEM LETZTEN**
OPERATING ELEMENT FOR THE ENGAGING AND EXTRACTION OF PLANAR SUB-ASSEMBLIES WITH COMBINED DISPLAY/SWITCHING ELEMENT IN AN OPERATING LEVER, FRONT SYSTEM FOR A PLANAR SUB-ASSEMBLY WITH OPERATING ELEMENT, PLANAR SUBASSEMBLY WITH THE LATTER AND SUB-ASSEMBLY SUPPORT WITH THE LATTER
ELEMENT D'ACTIONNEMENT POUR FAIRE ENTRER ET SORTIR DES MODULES PLATS AVEC ELEMENT D'AFFICHAGE/DE COMMUTATION COMBINE INTEGRE DANS UN LEVIER D'ACTIONNEMENT, ELEMENT FRONTAL POUR UN MODULE PLAT AVEC ELEMENT D'ACTIONNEMENT, MODULE PLAT AVEC CE DERNIER ET SUPPORT DE MODULES AVEC CE DERNIER

(30) Priorität: 17.08.2000 DE 20014196 U
(43) Veröffentlichungstag der Anmeldung: 04.09.2002
(73) Patentinhaber: Rittal Electronic Systems GmbH & Co. KG, 35745 Herborn (DE)
(72) Erfinder: KOERBER, Werner, 91282 Betzenstein (DE); SCHAFFER, Kurt, Michael, 90542 Eckental (DE); BEHRENS, Ralf, 90419 Nürnberg (DE)
(74) Vertreter: Fleck, Hermann-Josef
(86) Internationale Anmeldenummer: PCT/EP2001/009524
(87) Internationale Veröffentlichungsnummer: WO 2002/015657

(56) Entgegenhaltungen:
- WO-A-96/42187
- US-A- 5 627 379
- PATENT ABSTRACTS OF JAPAN vol. 2000, no. 02, 29. Februar 2000 (2000-02-29) & JP 11 307964 A (TOSHIBA CORP), 5. November 1999 (1999-11-05)
- PATENT ABSTRACTS OF JAPAN vol. 1995, no. 06, 31. Juli 1995 (1995-07-31) & JP 07 058462 A (NEC CORP), 3. März 1995 (1995-03-03)

## Beschreibung

Die Erfindung betrifft ein Betätigungselement zum Ein- und Aushebeln einer Flachbaugruppe mit den Merkmalen des Oberbegriffs des Patentanspruchs 1. Ferner betrifft die Erfindung ein Frontsystem für eine Flachbaugruppe mit mindestens einem derartigen Betätigungselement, eine zugehörige Flachbaugruppe sowie einen Baugruppenträger zur ein- und aushebelbaren Aufnahme derartiger Flachbaugruppen mit einem Frontsystem.

Als Stand der Technik ist aus der nachveröffentlichten Gebrauchsmusteranmeldung 299 22 725.1 (Siemens) oder die WO 96/42187 ein Betätigungselement zum Ein- und Aushebeln einer Flachbaugruppe mit einem Endstück bekannt, welches zur Verbindung mit einer Flachbaugruppe vorbereitet ist und einen Betätigungshebel aufweist, der drehbar am Endstück gelagert ist.

Derartige Flachbaugruppen weisen üblicherweise elektrische Anzeigeelemente auf, die z.B. den Schaltzustand eines Schaltelements der Frontbaugruppe anzeigen und dabei üblicherweise separat in der Frontplatte der Frontbaugruppe integriert sind. Hierfür wird separater Bauraum benötigt.

Der Erfindung liegt die Aufgabe zugrunde, ein Betätigungselement zum Ein- und Aushebeln einer Flachbaugruppe anzubieten, welches ein besonders platzsparend angebrachtes Anzeige- und Schaltelement aufweist. Ferner soll ein zugehöriges Frontsystem für eine derartige Flachbaugruppe, eine Flachbaugruppe mit einem derartigen Frontsystem sowie ein Baugruppenträger zur ein- und aushebelbaren Aufnahme derartiger Flachbaugruppen angeboten werden.

Die Aufgabe wird für das Betätigungselement durch die Merkmale des kennzeichnenden Teils des Patentanspruchs 1 in Verbindung mit den Merkmalen des Oberbegriffs gelöst. Vorteilhafte Ausführungsformen des Betätigungselements sind in den Unteransprüchen 2 - 14 beschrieben. Für das Frontsystem wird die Aufgabe durch die Merkmale des Patentanspruchs 15, für die Flachbaugruppe durch die Merkmale des Patentanspruchs 16 und für den Baugruppenträger durch die Merkmale des Patentanspruchs 17 gelöst.

Beim erfindungsgemäßen Betätigungselement weist dessen Betätigungshebel mindestens ein elektrisches kombiniertes Anzeige-/Schaltelement auf. Das erfindungsgemäße Anzeige-/Schaltelement ist als Kombinationselement bauraumsparend im Betätigungshebel angebracht. Üblicherweise ist ein separates Anzeigeelement z.B. in der Frontplatte der Flachbaugruppe vorgesehen und ist das Schaltelement getrennt von einem derartigen Anzeigeelement im Betätigungselement integriert. Damit müssen nach dem Stand der Technik das Anzeige- und das Schaltelement separat montiert werden. Erfindungsgemäß wird es nun ermöglicht, das kombinierte Anzeige-/Schaltelement montagefreundlich und bauraumsparend an Betätigungshebel anzubringen.

Das Anzeige-/Schaltelement besitzt ein Anzeigeteilelement, insbesondere ein LED-Bauelement, sowie ein Schaltteilelement. Anzeigeteilelement und Schaltteilelement können auf vielfältige Art und Weise miteinander verbunden und z.B. modulartig aneinander angebracht sein. Hierdurch können einzelne Schaltteilelemente bzw. Anzeigeteilelemente ausgetauscht oder ersetzt werden.

Vorteilhafterweise wird das kombinierte Anzeige-/Schaltelement teilweise oder völlig in das Verriegelungselement des Betätigungshebels integriert, wodurch ein geringer Abstand zu Stromversorgungskontakten der Flachbaugruppe besteht.

Gemäß einer-weiteren vorteilhaften Ausführungsform ist das kombinierte Anzeige-/Schaltelement im Verriegelungselement verstellbar, und zwar insbesondere mit dem Verriegelungselement verschiebbar angebracht. Damit kann das erfindungsgemäße kombinierte Anzeige-/Schaltelement mit dem Verriegelungselement in dessen Schaltstellungen A und B verschoben werden.

Wenn das Schaltteilelement des kombinierten Anzeige-/Schaltelements einen Schalthebel aufweist, wird dieser insbesondere beim Verschieben des Verriegelungselements in einer Schaltstellung betätigt und in der anderen Schaltstellung entlastet. Hierbei kann beim Aushebeln des Betätigungshebels zunächst durch Verschieben des Verriegelungselements z.B. in eine hintere Schaltstellung B eine Passivschaltung der Flachbaugruppe erfolgen. Danach kann durch die gleichzeitig in dieser Schaltstellung des Verriegelungselements vorliegende Entriegelung des Betätigungshebels danach ein Abdrehen des Betätigungshebels zum schließlichen Aushebeln der Flachbaugruppe erfolgen.

Vorteilhafterweise liegt der Schalthebel des Schaltteilelements an einem insbesondere feststehenden Anschlag des Betätigungshebels im betätigten Zustand an. Als ein derartiger Anschlag kann eine in einer Bohrung aufgenommene Drehachse des Betätigungshebels dienen. Diese Drehachse ist gegenüber dem verschiebbaren Verriegelungselement lagestabil, so dass sich ein mit dem Verriegelungselement verschobenes Schaltteilelement des kombinierten Anzeige-/Schaltelements in unterschiedlichen Abständen zur ortsfesten Drehwelle befindet und damit ein Schalthebel am Schaltteilelement in einer lagenahen Position des Verriegelungselements zur Drehwelle betätigt und in einer lagefernen Position entlastet werden kann.

Die Erfindung ist anhand von Ausführungsbeispielen in den Zeichnungsfiguren näher erläutert. Es zeigen:
- FIG 1: eine perspektivische Seitenansicht einer prinzipiel- len Ausführung eines Betätigungselements nach dem Stand der Technik,
- FIG 2: eine seitliche Draufsicht auf ein Frontsystem für ei- ne Flachbaugruppe mit einem Betätigungselement gemäß dem Stand der Technik nach FIG 1,
- FIG 3: eine Schnittdarstellung einer schematischen Ausfüh- rung eines erfindungsgemäßen Betätigungselements mit betätigtem Schaltelement sowie
- FIG 4: eine Schnittdarstellung einer schematischen Ausfüh- rung eines erfindungsgemäßen Betätigungselements ge- mäß FIG 3 mit entlastetem Schaltelement.

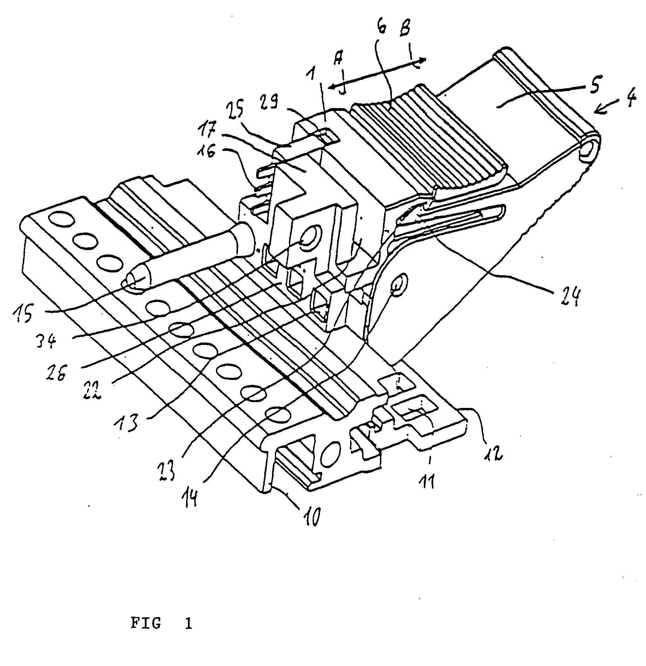

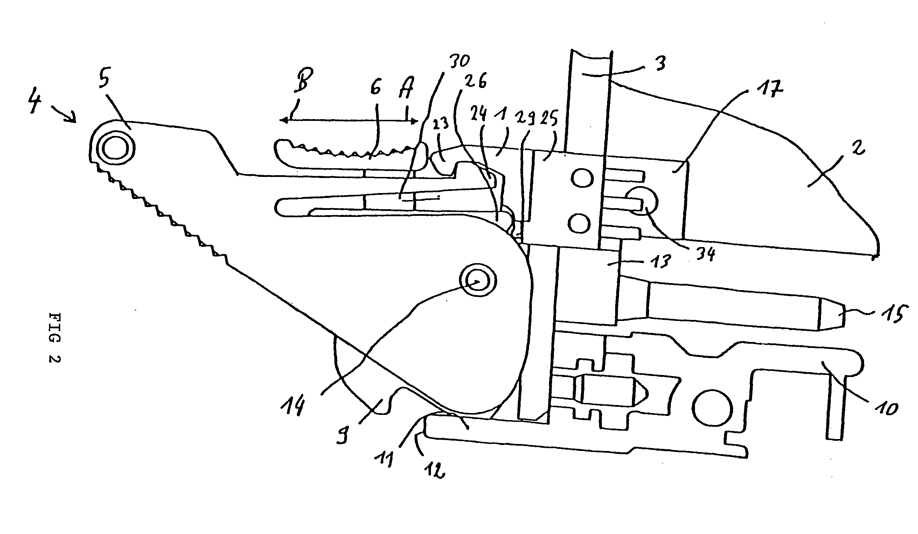

FIG 1 zeigt ein Betätigungselement nach dem Stand der Technik zum Ein- und Aushebeln einer Flachbaugruppe 2 mit einem Endstück 1 zur Verbindung mit einer Flachbaugruppe 2 und einer Frontplatte 3 (vgl. auch FIG 2).

Das Betätigungselement ruht dabei auf einer unteren Querschiene 10 eines Baugruppenträgers und weist dabei als Hauptkomponenten einen Betätigungshebel 4, ein Endstück 1 und eine aus Gründen der Übersichtlichkeit in FIG 1 nicht dargestellte Frontplatte 3 auf. Dem Endstück 1 kommt dabei eine zentrale Haltefunktion zu, da es zum einen als Träger für den insbesondere über eine Bohrung 14 drehbar gelagerten Betätigungshebel 4 dient. Andererseits kann es auch zur Halterung des unteren Endes der Frontplatte 3 dienen, welche hierzu vorteilhaft in eine Nut 22 eingeschoben wird.

Die Verbindung zwischen dem unteren Endstück 1 und der vorderen, unteren Ecke der Flachbaugruppe 2 (vgl. FIG 2) erfolgt bevorzugt über einen Halteblock 17 mittels einer in eine Bohrung 34 eingreifenden Schraube.

Schließlich können noch weitere Komponenten an einem derartigen Endstück 1 angebracht sein. So enthält das in FIG 1 dargestellte Endstück 1 einen Kodierblock 13, in welchem Kodierkammern 27 zum Einsetzen von nicht abgebildeten Kodierstiften eingebracht sind. Diese können in gegenüberliegend an der unteren Querschiene 10 angebrachten Kodierkammern eingreifen, welche mit komplementär kodierten Kodierstiften bestückt sind. Hiermit kann sichergestellt werden, dass nur eine bestimmte, ausgewählte Flachbaugruppe 2 in einem Steckplatz eines Baugruppenträgers positionierbar ist. Schließlich ist noch ein Führungsstift 15 vorhanden, welcher nach Eingriff in eine gegenüberliegende nicht abgebildete Führungsbohrung ein verkantfreies, ordnungsgemäßes Einschieben der Flachbaugruppe 2 gewährleistet.

Zum Ein- bzw. Aushebeln der Flachbaugruppe in den bzw. aus dem entsprechenden Steckplatz dient der Betätigungshebel 4, welcher durch Betätigung des Griffteils 5 bei Verbringung des Verriegelungselements 6 in Schaltstellung (B) bedient werden kann.

Beim Aushebeln muss der Betätigungshebel 4 nach unten gedrückt werden, so dass sich mindestens eine auf der Unterseite vorspringende Aushebelnase 9 an einer Stirnkante 12 der unteren Querschiene 10 abstützen kann. Umgekehrt muss beim Einhebeln der Betätigungshebel 4 nach oben gedrückt werden, so dass sich mindestens eine ebenfalls auf der Unterseite vorspringende Einhebelkante 8 im Inneren einer ebenfalls im Bereich der Stirnkante 12 der unteren Querschiene 10 befindlichen mindestens einen Eingriffsmulde 11 abstützen kann.

Üblicherweise sind am Endstück 1 noch Mittel vorhanden, über die der Betätigungshebel 4 bei Erreichen des in den Baugruppenträger vollständig eingeschobenen Zustands der Flachbaugruppe in der entsprechenden Position fixiert wird. Dieser eingeschobene Zustand ist in FIG 1 dargestellt. Vorteilhafterweise weist der Betätigungshebel 4 hierzu auf seiner Oberseite eine auf das Endstück 1 gerichtete, federnde und nach oben stehende Rastnase 24 auf, welche eine auf den Betätigungshebel 4 gerichtete und nach unten abgehende Rastkante 23 am Endstück 1 hintergreift.

In der gleichen Weise ist auch an dem in FIG 2 dargestellten Eckbereich der Flachbaugruppe 2 eine entsprechende Anordnung aus einem oberen Endstück 3 mit einem daran drehbar gelagerten oberen Betätigungshebel 4 angebracht. Dieser greift dann zum Ein- und Aushebeln in eine entsprechende obere Querschiene eines Baugruppenträgers ein (nicht abgebildet).

Bei dem Betätigungselement nach dem Stand der Technik gemäß FIG 1 und FIG 2 ist im unteren oder oberen Endstück ein Schaltelement 25 integriert, wobei dieses durch den Betätigungshebel 4 bei Vorliegen von dessen fixierter Position (Schaltstellung A) betätigt wird. Es ist hiermit möglich, die am Betätigungshebel 4 angebrachte Flachbaugruppe 2 elektrisch freizuschalten, z.B. durch Aktivierung von deren Stromversorgung. Umgekehrt kann die Flachbaugruppe 2 auch elektrisch passiv geschaltet werden, indem im Moment einer Aushebelung der Flachbaugruppe 2 der Eingriff des Betätigungshebel 4 auf das in das Endstück 1 integrierte Schaltelement 25 endet und durch diese Freigabe des Schaltelements 25 die elektrische Stromversorgung der Flachbaugruppe 2 wieder passiviert wird.

Das Schaltelement 25 ist in einem bis in den Bereich der Rastkante 23 des Endstücks 1 reichenden Aufnahmeschlitz 28 gelagert. Ein Schaltteil des Schaltelements 25, z.B. ein Schalthebel 29, ragt somit in den Bereich unterhalb der nach unten abgehenden Rastkante 23 hinein und wird bei Erreichen des fixierten Zustands des Betätigungshebels 4 (Schaltstellung A) durch den Schaltschieber 26 des Verriegelungselements 6 des Betätigungshebels 4 betätigt, wenn sich der Betätigungshebel 4 in der Position A befindet. Das Verriegelungselement 6 ist über ein Verbindungsteil 30 mit dem Schaltschieber 26 verbunden.

Wenn der Betätigungshebel 4 in die Position B (vgl. FIG 2) verschoben wird, wird der Schalthebel 29 entlastet und das Schaltelement 25 in einen zweiten Schaltzustand umgeschaltet, wobei insbesondere eine Passivierung der Flachbaugruppe 2 erfolgt.

Daraufhin kann ein Aushebeln des Betätigungshebels 4 erfolgen, in dem dessen Griffteil 5 nach unten - in Richtung der Querschiene 10 - bewegt wird, wodurch sich die Rastnase 24 des Betätigungshebels 4 elastisch von der Rastkante 23 des Endstücks 1 löst. Durch die Verschiebung des Verriegelungselements 6 zwischen den Positionen A und B nach FIG 2 kann das Schaltelement 25 aktiviert und passiviert werden, und zwar unabhängig von einem vollständigen Lösen des Betätigungselements durch das geschilderte Aushebeln des Betätigungshebels 4 nach unten zum Herausnehmen der Flachbaugruppe 2 aus dem Baugruppenträger.

Weitere Einzelheiten zum Aufbau des Betätigungselements gemäß dem Stand der Technik nach den FIG 1 und 2 und insbesondere zur Funktion des Verriegelungselements 6 gehen aus der Gebrauchsmusteranmeldung 299 22 725.1 (Siemens) hervor.

Vorteilhafterweise ist das integrierte Schaltelement 25 über eine an dessen Anschlusskontakten 16 anbringbare Kabel- oder Kabelsteckverbindung mit der Flachbaugruppe 2 elektrisch verbindbar.

Es ist somit möglich, das Schaltelement 25 dauerhaft sicher und verschleißfrei über das Betätigungselement zu betätigen, wenn die Schaltmittel des Schaltelements 25 nur einen sehr geringen Schaltweg aufweisen.

Da die Aktiv-Passiv-Schaltfunktion vollständig in das Betätigungselement integriert ist, unterliegen Anwender des Frontsystems keiner Einschränkung bezüglich der Positionierung von Bauelementen auf einer mit einem derartigen Frontsystem ausgestatteten Flachbaugruppe. Insbesondere sind dort keine maßlich genauen Positionsfestlegungen bezüglich elektrischer Anschlüsse für das Schaltelement 25 erforderlich.

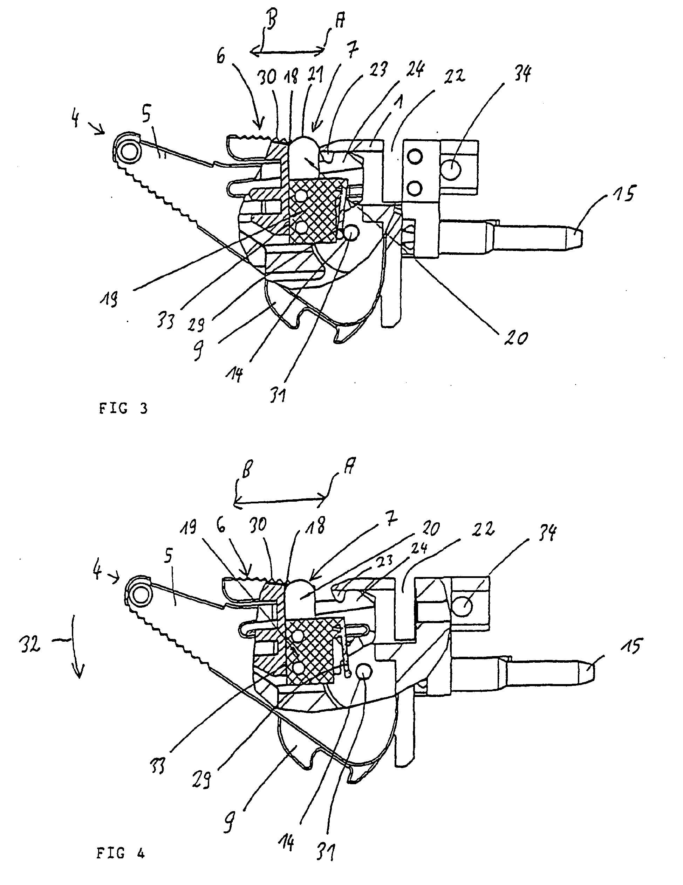

Soweit der Aufbau des erfindungsgemäßen Betätigungselements gemäß den FIG 3 und 4 dem Aufbau des Betätigungselements nach dem Stand der Technik gemäß FIG 1 und FIG 2 entspricht, wurden identische Bezugszeichen verwendet, welche ohne ergänzende Erläuterung auch die bei der Figurenbeschreibung nach FIG 1 und FIG 2 dargestellten Funktionen besitzen.

FIG 3 zeigt eine Schnittdarstellung eines erfindungsgemäßen Betätigungselements (ohne Querschiene 10, Flachbaugruppe 2, Frontplatte 3 gemäß FIG 1 und 2) mit einem im Verriegelungselement 6 aufgenommenen kombinierten Anzeige-/Schaltelement 7 mit einem Schaltteilelement 19 und einem Anzeigeteilelement 20. Das Anzeige-/Schaltelement 7 ist in einer Ausnehmung 18 des Verriegelungselements 6 aufgenommen. Dabei ist das Anzeigeteilelement 20 direkt auf dem Schaltteilelement 19 angebracht und vorteilhafterweise durch innenliegende Kontakte elektrisch mit dem Anzeigeteilelement 20 verbunden.

In FIG 3 befindet sich das Verriegelungselement 6 in der Schaltstellung A, so dass das Anzeigeteilelement 20 des kombinierten Anzeige-/Schaltelements 7 an der Kante 23 des Endstücks 1 anliegt. Die Kante 23 des Endstücks 1 kann dabei als Anschlag des Anzeigeteilelements 20 und damit des Verriegelungselements 6 dienen.

In der in FIG 3 abgebildeten Schaltstellung A des Verriegelungselements 6 ist der Schalthebel 29 des Schaltteilelements 19 betätigt und liegt an der in einer Bohrung 14 aufgenommenen Drehachse 31 des Betätigungshebels 4 an.

Wenn das Verriegelungselement 6 nun in die Schaltstellung B verbracht wurde (vgl. FIG 4), ist der federnde oder elastische Schalthebel 29 des Schaltteilelements 19 entlastet und liegt nicht mehr an der Drehachse 31 an. Damit hat das Schaltteilelement 19 seinen Schaltzustand gewechselt und z.B. die in den FIG 3 und 4 nicht abgebildeten Flachbaugruppe 2 passiv geschaltet. Daraufhin kann ein Aushebeln des Betätigungshebels 4 in Drehrichtung 32 erfolgen, wodurch sich die Rastnase 24 nach unten abdrückt und sich vom Eingriff der Kante 23 des Endstücks 1 löst.

Erfindungsgemäß wird ermöglicht, dass vor dem Aushebeln des Betätigungshebels 4 in Drehrichtung 32 eine definierte und präzise Passivschaltung der Flachbaugruppe 2 durch Verschieben des Verriegelungselements 6 in Schaltstellung B und damit durch Umschaltung des Schaltteilelements 19 des kombinierten Anzeige-/Schaltelements 7 stattfindet.

Das Anzeigeteilelement 20 und/oder das Schaltteilelement 19 des kombinierten Anzeige-/Schaltelements 7 besitzen an sich bekannte Bewegungsanschlußkontakte (z.B. Kontaktschienen) zur Verbindung mit stationären im Endstück 1 angebrachten Anschlusskontakten zur Stromversorgung mit der Flachbaugruppe 2 (nicht abgebildet).

Das Anzeigeteilelement 20 des kombinierten Anzeige-/Schaltelements 7 ist insbesondere als LED-Bauelement ausgebildet und kann zur Anzeige von Schaltzuständen des Schalthebels 29 des Schaltteilelements 19 dienen.

Die Oberfläche 21 des Anzeigeteilelements 20 schließt im wesentlichen bündig mit der Oberfläche 30 des Verriegelungselements 6 ab. Damit ist das kombinierte Anzeige-/Schaltelement 7 vertieft im Verriegelungselement 6 aufgenommen.

Das Schaltteilelement 19 kann zur Befestigung des kombinierten Anzeige-/Schaltelements 7 mit einem Kontaktbereich 33 des Verriegelungselements 6 verbunden sein. Bei einer Verschiebung des Verriegelungselements 6 von der Schaltstellung A zu B und zurück kann die Bewegung des Verriegelungselements 6 über diesen Kontaktbereich 33 auf das kombinierte Anzeige-/Schaltelement 7 übertragen werden.

## Patentansprüche

1. Betätigungselement zum Ein- und Aushebeln einer Flachbaugruppe (2), mit
a) einem Endstück (1), welches zur Verbindung mit einer Flachbaugruppe (2) vorbereitet ist und
b) einem Betätigungshebel (4), der drehbar am Endstück (1) gelagert ist und zumindest aufweist,
b1) ein Griffteil (5) und
b2) ein Verriegelungselement (6), das zwischen zumindest zwei Schaltstellungen (A, B) verstellbar, insbesondere verschiebbar ist und das
b22) in einer ersten Schaltstellung (A) den Betätigungshebel (4) in einer ersten Position hält, welche einem eingehebelten Zustand der Flachbaugruppe (2) entspricht, und der
b23) in einer zweiten Schaltstellung (B) den Betätigungshebel (4) freigibt,
**dadurch gekennzeichnet, dass** der Betätigungshebel (4) mindestens ein kombiniertes Anzeige-/Schaltelement (7) aufweist.

2. Betätigungselement nach Anspruch 1,
**dadurch gekennzeichnet, dass** das kombinierte Anzeige-/Schaltelement (7) am Verriegelungselement (6) angebracht ist.

3. Betätigungselement nach Anspruch 2,
**dadurch gekennzeichnet, dass** das kombinierte Anzeige-/Schaltelement (7) teilweise in das Verriegelungselement (6) integriert ist.

4. Betätigungselement nach Anspruch 2,
**dadurch gekennzeichnet, dass** das kombinierte Anzeige-/Schaltelement (7) vollständig in das Verriegelungselement (6) integriert ist.

5. Betätigungselement nach einem der vorhergehenden Ansprüche,
**dadurch gekennzeichnet, dass** das kombinierte Anzeige-/Schaltelement (7) in einer Ausnehmung (18) des Verriegelungselements (6) angebracht ist.

6. Betätigungselement nach einem der vorhergehenden Ansprüche,
**dadurch gekennzeichnet, dass** das kombinierte Anzeige-/Schaltelement (7) und das Verriegelungselement (6) zwischen dessen zwei Schaltstellungen (A, B) verstellbar angebracht ist.

7. Betätigungselement nach einem der vorhergehenden Ansprüche,
**dadurch gekennzeichnet, dass** das Anzeige-/Schaltelement (7) ein Schaltteilelement (19) mit einem Schalthebel (29) aufweist.

8. Betätigungselement nach Anspruch 7,
**dadurch gekennzeichnet, dass** der Schalthebel (29) des Schaltelements (19) bei einem in der Schaltstellung (A) befindlichen Verriegelungselement (6) betätigt und bei einem in der Schaltstellung (B) befindlichen Verriegelungselement (6) entlastet ist.

9. Betätigungselement nach einem der vorhergehenden Ansprüche,
**dadurch gekennzeichnet, dass** das kombinierte Anzeige-/Schaltelement (7) ein Anzeigeteilelement (20) aufweist.

10. Betätigungselement nach Anspruch 9,
**dadurch gekennzeichnet, dass** das Anzeigeteilelement (20) eine Oberfläche (21) aufweist, die im wesentlichen bündig mit einer Oberfläche (30) des Verriegelungselements (6) abschließt.

11. Betätigungselement nach einem der Ansprüche 9 oder 10,
**dadurch gekennzeichnet, dass** das Anzeigeteilelement (20) elektrisch mit dem Schaltteilelement (19) verbunden ist.

12. Betätigungselement nach einem der Ansprüche 7 - 11,
**dadurch gekennzeichnet, dass** der Schalthebel (29) des Schaltteilelements (19) im betätigten Zustand an einem Anschlag des Betätigungshebels (4) anliegt.

13. Betätigungselement nach Anspruch 12,
**dadurch gekennzeichnet, dass** der Anschlag eine feststehende Position zum verstellbaren Verriegelungselement (6) aufweist.

14. Betätigungselement nach einem der Ansprüche 12 oder 13,
**dadurch gekennzeichnet, dass** der Anschlag durch eine in einer Bohrung (14) des Betätigungshebels (4) aufgenommenen Drehachse (31) gebildet wird.

15. Frontsystem für eine Flachbaugruppe (2), welches aufweist eine Frontplatte (3) und mindestens ein Betätigungselement nach einem der vorangegangenen Ansprüche 1 - 14, das an einem Ende der Frontplatte (3) angebracht ist.

16. Flachbaugruppe (2) mit einem Frontsystem nach Anspruch 15.

17. Baugruppenträger mit mindestens einer Flachbaugruppe (2) nach Anspruch 16.

## Claims

1. Operating element for levering a printed circuit board assembly (2) in and out, having
a) an end piece (1) which is prepared for connection to a printed circuit board assembly (2), and
b) an operating lever (4) which is mounted on the end piece (1) so that it can rotate and has at least:
b1) a grip part (5) and
b2) a locking element (6), which can be moved, in particular moved linearly, between at least two switch positions (A, B) and which
b22) in a first switch position (A), holds the operating lever (4) in a first position which corresponds to a levered-in state of the printed circuit board assembly (2), and
b23) in a second switch position (B), releases the operating lever (4),
**characterized in that** the operating lever (4) has at least one combined indication/switching element (7).

2. Operating element according to Claim 1,
**characterized in that** the combined indication/switching element (7) is fitted to the locking element (6).

3. Operating element according to Claim 2,
**characterized in that** the combined indication/switching element (7) is partially integrated in the locking element (6).

4. Operating element according to Claim 2,
**characterized in that** the combined indication/switching element (7) is completely integrated in the locking element (6).

5. Operating element according to one of the preceding claims,
**characterized in that** the combined indication/switching element (7) is fitted in a recess (18) in the locking element (6).

6. Operating element according to one of the preceding claims,
**characterized in that** the combined indication/switching element (7) and the locking element (6) are fitted such that they can be moved between the two switch positions (A, B) thereof.

7. Operating element according to one of the preceding claims,
**characterized in that** the indication/switching element (7) has a switching part element (19) with a switching lever (29).

8. Operating element according to Claim 7,
**characterized in that** the switching lever (29) of the switching element (19) is operated when a locking element (6) is in the switch position (A), and is unloaded when a locking element (6) is in the switch position (B).

9. Operating element according to one of the preceding claims,
**characterized in that** the combined indication/switching element (7) has an indication part element (20).

10. Operating element according to Claim 9,
**characterized in that** the indication part element (20) has a surface (21) which ends essentially flush with one surface (30) of the locking element (6).

11. Operating element according to one of Claims 9 or 10,
**characterized in that** the indication part element (20) is electrically connected to the switching part element (19).

12. Operating element according to one of Claims 7 to 11,
**characterized in that** the switching lever (29) of the switching part element (19) rests on a stop on the operating lever (4) in the operated state.

13. Operating element according to Claim 12,
**characterized in that** the stop has a stationary position with respect to the movable locking element (6).

14. Operating element according to one of Claims 12 or 13,
**characterized in that** the stop is formed by a rotating shaft (31) which is held in a hole (14) in the operating lever (4).

15. Front system for a printed circuit board assembly (2), which has a front panel (3) and at least one operating element according to one of the preceding Claims 1 to 14, which is fitted to one end of the front panel (3).

16. Printed circuit board assembly (2) having a front system according to Claim 15.

17. Mounting rack having at least one printed circuit board assembly (2) according to Claim 16.

## Revendications

1. Elément d'actionnement pour faire entrer et sortir un module plat (2), comprenant :
a) un élément d'extrémité (1) qui est prévu pour être raccordé à un module plat (2) et
b) un levier d'actionnement (4) qui est monté de manière à pouvoir tourner sur l'élément d'extrémité (1) et qui présente au moins :
b1) une partie de préhension (5) et
b2) un élément de verrouillage (6) qui peut être déplacé entre au moins deux positions de commutation (A, B), en particulier par coulissement, et qui
b22) dans une première position de commutation (A), maintient le levier d'actionnement (4) dans une première position, qui correspond à un état rentré du module plat (2), et qui
b23) dans une deuxième position de commutation (B), libère le levier d'actionnement (4),
**caractérisé en ce que** le levier d'actionnement (4) présente au moins un élément combiné d'affichage / de commutation (7).

2. Elément d'actionnement selon la revendication 1, **caractérisé en ce que** l'élément combiné d'affichage / de commutation (7) est monté sur l'élément de verrouillage (6).

3. Elément d'actionnement selon la revendication 2, **caractérisé en ce que** l'élément combiné d'affichage / de commutation (7) est partiellement intégré dans l'élément de verrouillage (6).

4. Elément d'actionnement selon la revendication 2, **caractérisé en ce que** l'élément combiné d'affichage / de commutation (7) est complètement intégré dans l'élément de verrouillage (6).

5. Elément d'actionnement selon l'une quelconque des revendications précédentes, **caractérisé en ce que** l'élément combiné d'affichage / de commutation (7) est monté dans un évidement (18) de l'élément de verrouillage (6).

6. Elément d'actionnement selon l'une quelconque des revendications précédentes, **caractérisé en ce que** l'élément combiné d'affichage / de commutation (7) et l'élément de verrouillage (6) sont montés de manière déplaçable entre leurs deux positions de commutation (A, B).

7. Elément d'actionnement selon l'une quelconque des revendications précédentes, **caractérisé en ce que** l'élément d'affichage / de commutation (7) présente un élément formant partie de commutation (19), avec un levier de commutation (29).

8. Elément d'actionnement selon la revendication 7, **caractérisé en ce que** le levier de commutation (29) de l'élément de commutation (19) est actionné lorsque l'élément de verrouillage (6) se trouve dans la position de commutation (A) et est déchargé lorsque l'élément de verrouillage (6) se trouve dans la position de commutation (B).

9. Elément d'actionnement selon l'une quelconque des revendications précédentes, **caractérisé en ce que** l'élément combiné d'affichage / de commutation (7) présente un élément formant partie d'affichage (20).

10. Elément d'actionnement selon la revendication 9, **caractérisé en ce que** l'élément formant partie d'affichage (20) présente une surface (21) qui se termine essentiellement en affleurement avec une surface (30) de l'élément de verrouillage (6).

11. Elément d'actionnement selon l'une quelconque des revendications 9 ou 10, **caractérisé en ce que** l'élément formant partie d'affichage (20) est connecté électriquement à l'élément formant partie de commutation (19).

12. Elément d'actionnement selon l'une quelconque des revendications 7 à 11, **caractérisé en ce que** le levier de commutation (29) de l'élément formant partie de commutation (19) s'applique dans l'état actionné contre une butée du levier d'actionnement (4) .

13. Elément d'actionnement selon la revendication 12, **caractérisé en ce que** la butée présente une position fixe pour l'élément de verrouillage déplaçable (6).

14. Elément d'actionnement selon l'une quelconque des revendications 12 ou 13, **caractérisé en ce que** la butée est formée par un axe de rotation (31) reçu dans un alésage (14) du levier d'actionnement (4).

15. Système frontal pour un module plat (2) qui présente une plaque frontale (3) et au moins un élément d'actionnement selon l'une quelconque des revendications précédentes 1 à 14, qui est monté à une extrémité de la plaque frontale (3).

16. Module plat (2) comprenant un système frontal selon la revendication 15.

17. Support de modules comprenant au moins un module plat (2) selon la revendication 16.
